(19) Europäisches Patentamt
European Patent Office
Office européen des brevets

(11) **EP 4 787 713 A1**

(12) **EUROPEAN PATENT APPLICATION**
published in accordance with Art. 153(4) EPC

(43) Date of publication:
**05.08.2026 Bulletin 2026/32**

(21) Application number: **24870094.0**

(22) Date of filing: **02.08.2024**

(51) International Patent Classification (IPC):
**H03M 1/10** (2006.01)    **G01R 35/00** (2006.01)

(52) Cooperative Patent Classification (CPC):
**G01R 19/00; G01R 35/00; H03M 1/10**

(86) International application number:
**PCT/CN2024/109465**

(87) International publication number:
**WO 2025/066545 (03.04.2025 Gazette 2025/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.09.2023 CN 202311277380**

(71) Applicant: **Contemporary Amperex Technology
Co., Limited
Ningde, Fujian 352100 (CN)**

(72) Inventors:
• **CHEN, Weijie
Ningde, Fujian 352100 (CN)**
• **YE, Fuming
Ningde, Fujian 352100 (CN)**
• **LI, Qiandeng
Ningde, Fujian 352100 (CN)**

(74) Representative: **Lorenz Seidler Gossel Part. mbB
Widenmayerstr. 23
80538 München (DE)**

(54) **SAMPLING CIRCUIT AND CALIBRATION METHOD THEREFOR, BATTERY MANAGEMENT SYSTEM, AND ELECTRIC DEVICE**

(57)    A sampling circuit and a calibration method therefor, a battery management system, and an electric device. The calibration method comprises: acquiring the voltage of a first type sampling point and the voltage of a second type sampling point (S101); on the basis of the voltage of the first type sampling point and the voltage of the second type sampling point, determining a calibration factor corresponding to the first type sampling point (S102); and on the basis of the calibration factor, correcting the voltage of the first type sampling point to obtain the corrected voltage of the first type sampling point (S103).

FIG. 1

Processed by Luminess, 75001 PARIS (FR)

## Description

CROSS-REFERENCE TO RELATED APPLICATION

The present application claims priority to Chinese Patent Application No. 202311277380.9 filed on September 28, 2023 and entitled "SAMPLING CIRCUIT AND CALIBRATION METHOD THEREFOR, BATTERY MANAGEMENT SYSTEM, AND ELECTRIC DEVICE", the content of which is incorporated herein by reference in its entirety.

TECHNICAL FIELD

The present application relates to the field of batteries, and in particular, to a sampling circuit and a calibration method therefor, a battery management system, and an electric device.

BACKGROUND

With the increasing severity of environmental pollution, the market demand for new energy vehicles continues to expand, and the requirements for new energy vehicle technologies have also become increasingly stringent, particularly with respect to the safety performance of new energy vehicles. To improve the safety of new energy vehicles, it is necessary to sample some devices to be tested (such as batteries) in the new energy vehicles.

However, the inventors of the present application have found through research that the devices in the sampling circuit may age over time, which causes the sampling precision at some sampling points in the sampling circuit to deteriorate, thereby resulting in relatively low accuracy of the sampling results.

SUMMARY

The present application provides a sampling circuit and a calibration method therefor, a battery management system, and an electric device, to resolve the problem of relatively poor sampling precision at sampling points in the sampling circuit.

In a first aspect, the present application provides a method for calibrating a sampling circuit. The calibration method includes: acquiring a voltage at a first-type sampling point and a voltage at a second-type sampling point; determining calibration factors corresponding to the first-type sampling point based on the voltage at the first-type sampling point and the voltage at the second-type sampling point; and correcting the voltage at the first-type sampling point based on the calibration factors to obtain a corrected voltage at the first-type sampling point.

In the technical solutions of the embodiments of the present application, the calibration factors corresponding to the first-type sampling point are calculated by using the voltage at the second-type sampling point with relatively high sampling precision, and the voltage at the first-type sampling point is corrected based on the calibration factors to obtain the corrected voltage at the first-type sampling point, which allows the sampling precision at the first-type sampling point to be the same as or similar to that at the second-type sampling point. That is, the sampling precision at the first-type sampling point in the sampling circuit is improved, thereby ensuring relatively high accuracy of the sampling results.

According to some embodiments of the present application, optionally, determining the calibration factors corresponding to the first-type sampling point based on the voltage at the first-type sampling point and the voltage at the second-type sampling point includes: determining the calibration factors corresponding to the first-type sampling point based on voltages at the first-type sampling point at a plurality of moments and voltages at the second-type sampling point at the plurality of moments.

According to some embodiments of the present application, optionally, determining the calibration factors corresponding to the first-type sampling point based on the voltage at the first-type sampling point and the voltage at the second-type sampling point includes: establishing a relationship between the voltage at the first-type sampling point and the voltage at the second-type sampling point based on the voltages at the first-type sampling point at the plurality of moments and the voltages at the second-type sampling point at the plurality of moments; and determining the calibration factors corresponding to the first-type sampling point based on the relationship between the voltage at the first-type sampling point and the voltage at the second-type sampling point.

According to some embodiments of the present application, optionally, determining the calibration factors corresponding to the first-type sampling point based on the voltage at the first-type sampling point and the voltage at the second-type sampling point includes: establishing a first relationship between the voltage at the first-type sampling point and the voltage at the second-type sampling point based on a voltage at the first-type sampling point acquired at a first moment and a voltage at the second-type sampling point acquired at the first moment; establishing a second relationship between the voltage at the first-type sampling point and the voltage at the second-type sampling point based on a voltage at the first-type sampling point acquired at a second moment and a voltage at the second-type sampling point acquired at the second moment; and determining the calibration factors corresponding to the first-type sampling point based on the first relationship and the second relationship.

According to some embodiments of the present application, optionally, the voltage at the first-type sampling point includes a voltage at the first-type sampling point with respect to a first reference potential, and the voltage at the second-type sampling point includes a voltage at the second-type sampling point with respect to a second reference potential; establishing the first relationship between the voltage at the first-type sampling point and the voltage at the second-type sampling point based on the voltage at the first-type sampling point acquired at the first moment and the voltage at the second-type sampling point acquired at the first moment includes: establishing the first relationship between the voltage at the first-type sampling point and the voltage at the second-type sampling point based on a voltage difference value between the first reference potential and the second reference potential, and the voltage at the first-type sampling point acquired at the first moment and the voltage at the second-type sampling point acquired at the first moment.

According to some embodiments of the present application, optionally, establishing the second relationship between the voltage at the first-type sampling point and the voltage at the second-type sampling point based on the voltage at the first-type sampling point acquired at the second moment and the voltage at the second-type sampling point acquired at the second moment includes: establishing the second relationship between the voltage at the first-type sampling point and the voltage at the second-type sampling point based on the voltage difference value between the first reference potential and the second reference potential, and the voltage at the first-type sampling point acquired at the second moment and the voltage at the second-type sampling point acquired at the second moment.

According to some embodiments of the present application, optionally, the calibration factors include a first calibration parameter and a second calibration parameter; correcting the voltage at the first-type sampling point based on the calibration factors to obtain the corrected voltage at the first-type sampling point includes: calculating a product of the voltage at the first-type sampling point and the first calibration parameter; and calculating a sum of the product and the second calibration parameter to obtain the corrected voltage at the first-type sampling point.

According to some embodiments of the present application, optionally, the voltage at the first-type sampling point includes the voltage at the first-type sampling point with respect to the first reference potential, and the voltage at the second-type sampling point includes the voltage at the second-type sampling point with respect to the second reference potential; calculating the sum of the product and the second calibration parameter to obtain the corrected voltage at the first-type sampling point includes: calculating the voltage difference value between the first reference potential and the second reference potential, and the sum of the product and the second calibration parameter to obtain the corrected voltage at the first-type sampling point.

In a second aspect, the present application provides a sampling circuit. The sampling circuit includes: a first-type sampling branch, where the first-type sampling branch is electrically connected to a device to be tested, and the first-type sampling branch is provided with a first-type voltage divider module and a first-type sampling point; a second-type sampling branch, where the second-type sampling branch is electrically connected to the device to be tested, and the second-type sampling branch is provided with a second-type voltage divider module, a switch module, and a second-type sampling point; and a sampling and processing module, where the sampling and processing module is electrically connected to the first-type sampling point and the second-type sampling point, respectively, the sampling and processing module is configured to correct a voltage at the first-type sampling point based on calibration factors, and the calibration factors are determined based on the voltage at the first-type sampling point and a voltage at the second-type sampling point.

According to some embodiments of the present application, optionally, the first-type sampling branch is electrically connected to a first reference voltage terminal, and the second-type sampling branch is electrically connected to a second reference voltage terminal; the voltage at the first-type sampling point includes a voltage at the first-type sampling point with respect to the first reference voltage terminal, and the voltage at the second-type sampling point includes a voltage at the second-type sampling point with respect to the second reference voltage terminal.

According to some embodiments of the present application, optionally, the first-type sampling branch includes a first sampling branch, a first terminal of the first sampling branch is electrically connected to a first electrode of the device to be tested, a second terminal of the first sampling branch is electrically connected to the first reference voltage terminal, and the first-type sampling point includes a first sampling point located on the first sampling branch; the second-type sampling branch includes a second sampling branch, a first terminal of the second sampling branch is electrically connected to the first electrode of the device to be tested, a second terminal of the second sampling branch is electrically connected to the second reference voltage terminal, the second-type sampling point includes a second sampling point located on the second sampling branch, the switch module includes a first switch module, and sampling is performed at the second sampling point when the first switch module is turned on.

According to some embodiments of the present application, optionally, the first-type sampling branch includes a third sampling branch, a first terminal of the third sampling branch is electrically connected to the first reference voltage terminal, a second terminal of the third sampling branch is electrically connected to a second electrode of the device to be tested, and the first-type sampling point includes a third sampling point located on the third sampling branch; the second-type sampling branch includes a fourth sampling branch, a first terminal of the fourth sampling branch is electrically connected to the second reference voltage terminal, a second terminal of the fourth sampling branch is electrically connected to the second electrode of the device to be tested, the second-type sampling point includes a fourth sampling point located on the fourth sampling branch, the switch module includes a second switch module, and sampling is performed at the fourth sampling point when the second switch module is turned on.

According to some embodiments of the present application, optionally, the sampling circuit further includes a third switch module, and a first terminal of the third switch module is electrically connected to the first electrode of the device to be tested; the first-type sampling branch further includes a fifth sampling branch, a first terminal of the fifth sampling branch is electrically connected to a second terminal of the third switch module, a second terminal of the fifth sampling branch is electrically connected to the first reference voltage terminal, and the first-type sampling point further includes a fifth sampling point located on the fifth sampling branch.

According to some embodiments of the present application, optionally, the sampling circuit further includes a fourth switch module, and a first terminal of the fourth switch module is electrically connected to the second electrode of the device to be tested; the first-type sampling branch further includes a sixth sampling branch, a first terminal of the sixth sampling branch is electrically connected to the first reference voltage terminal, a second terminal of the sixth sampling branch is electrically connected to a second terminal of the fourth switch module, and the first-type sampling point further includes a sixth sampling point located on the sixth sampling branch.

According to some embodiments of the present application, optionally, a voltage at the first reference voltage terminal is greater than 0 V and less than the maximum value of a sampling range of a sampling chip.

According to some embodiments of the present application, optionally, the first sampling branch includes a first voltage divider module, a second voltage divider module, and the first sampling point; a first terminal of the first voltage divider module is electrically connected to the first electrode of the device to be tested, and a second terminal of the first voltage divider module is electrically connected to the first sampling point; a first terminal of the second voltage divider module is electrically connected to the first sampling point, and a second terminal of the second voltage divider module is electrically connected to the first reference voltage terminal; a sum of a resistance value of the first voltage divider module and a resistance value of the second voltage divider module is in a value range of 25 to 30 megaohms.

According to some embodiments of the present application, optionally, the sampling circuit further includes a follower; a first input terminal of the follower is electrically connected to the first-type sampling point, a second input terminal of the follower is electrically connected to an output terminal of the follower, a first power input terminal of the follower is electrically connected to a positive power voltage signal terminal, a second power input terminal of the follower is electrically connected to a ground terminal, and the output terminal of the follower is electrically connected to a voltage acquisition terminal of the sampling chip; a potential reference terminal of the sampling chip is electrically connected to the ground terminal.

In a third aspect, the present application provides a battery management system. The battery management system includes the sampling circuit according to the second aspect.

In a fourth aspect, the present application provides an electric device. The electric device includes the battery management system according to the third aspect.

BRIEF DESCRIPTION OF THE DRAWINGS

Features, advantages, and technical effects of exemplary embodiments of the present application will be described below with reference to the drawings.

FIG. 1 is a schematic flowchart of a method for calibrating a sampling circuit according to an embodiment of the present application;
FIG. 2 is a schematic diagram of a circuit connection of a sampling circuit according to an embodiment of the present application;
FIG. 3 is a schematic flowchart of S102 in a method for calibrating a sampling circuit according to an embodiment of the present application;
FIG. 4 is another schematic flowchart of a method for calibrating a sampling circuit according to an embodiment of the present application;
FIG. 5 is a schematic flowchart of S103 in a method for calibrating a sampling circuit according to an embodiment of the present application;
FIG. 6 is another schematic diagram of a circuit connection of a sampling circuit according to an embodiment of the present application;
FIG. 7 is yet another schematic flowchart of a method for calibrating a sampling circuit according to an embodiment of the present application;
FIG. 8 is a schematic diagram of yet another circuit connection of a sampling circuit according to an embodiment of the present application;
FIG. 9 is a schematic diagram of yet another circuit connection of a sampling circuit according to an embodiment of the present application; and
FIG. 10 is a schematic diagram of yet another circuit connection of a sampling circuit according to an embodiment of the present application.

The drawings are not necessarily drawn to scale.

DETAILED DESCRIPTION

To make the objectives, technical solutions, and advantages of embodiments of the present application clearer, the technical solutions in the embodiments of the present application will be clearly and comprehensively described hereinafter with reference to the drawings in the embodiments of the present application. It is obvious that the described embodiments are some, but not all, embodiments of the present application. Based on the embodiments in the present application, all other embodiments obtained by those of ordinary skill in the art without creative work shall fall within the protection scope of the present application.

Embodiments of the technical solutions of the present application will be described in detail below with reference to the drawings. The following embodiments are only used to more clearly illustrate the technical solutions of the present application, and therefore, are only exemplary and do not limit the protection scope of the present application.

It should be noted that, unless otherwise specified, the technical or scientific terms used in the embodiments of the present application shall have ordinary meanings understood by those skilled in the art to which the embodiments of the present application belong.

In the description of the embodiments of the present application, the technical terms "first" and "second" are used for description only and are not to be construed as indicating or implying relative importance or implicitly specifying the number of technical features indicated. In the description of the embodiments of the present application, unless otherwise specifically defined, "plurality of" means two or more.

In the description of the embodiments of the present application, unless otherwise clearly specified and defined, the technical terms "mount", "interconnect", "connect", "fix", and the like should be interpreted in their broad senses. For example, they may be a fixed connection, a detachable connection, or an integral connection; a mechanical connection or an electrical connection; or a direct connection, an indirect connection via an intermediate, a communication between interiors of two elements, or an interaction between two elements. For those of ordinary skill in the art, the specific meanings of the above terms in the embodiments of the present application can be interpreted according to specific conditions.

In the description of the embodiments of the present application, unless otherwise clearly specified and defined, a first feature being "above" or "below" a second feature may be that the first feature and the second feature are in direct contact, or that the first feature and the second feature are in indirect contact via an intermediate. Moreover, a first feature being "over", "above", and "on top of" a second feature may be that the first feature is right above or obliquely above the second feature, or may simply mean that the first feature is at a higher horizontal level than the second feature. A first feature being "under", "below", and "beneath" a second feature may be that the first feature is right under or obliquely under the second feature, or may simply mean that the first feature is at a lower horizontal level than the second feature.

To improve the safety of new energy vehicles, it is usually necessary to sample some devices to be tested (such as batteries) in the new energy vehicles. In the embodiments of the present application, for example, the device to be tested includes, but is not limited to, a power battery. The power battery includes, but is not limited to, a lithium-ion battery, a lithium metal battery, a lead-acid battery, a nickel-cadmium battery, a nickel-metal hydride battery, a lithium sulfur battery, a lithium-air battery, or a sodium-ion battery. This is not limited herein. In terms of scale, the power battery may be a single cell, or may be a battery module or a battery pack. This is not limited herein.

The inventors have noticed that the devices in the sampling circuit may age over time, which causes the sampling precision at some sampling points in the sampling circuit to deteriorate, thereby resulting in relatively low accuracy of the sampling results. In particular, in some sampling branches in the sampling circuit, to protect the devices and reduce costs, these sampling branches typically use voltage divider modules (such as resistors) with relatively large resistance values and relatively low precision. Over time, the voltage divider modules may age, and the precision of these voltage divider modules with relatively large resistance values and relatively low precision may further decrease, which causes the sampling precision at the sampling points in these sampling branches to deteriorate, thereby resulting in relatively low accuracy of the sampling results.

To solve the above technical problem, the present application provides a sampling circuit and a calibration method therefor, a battery management system, and an electric device. Calibration factors corresponding to a first-type sampling point are calculated by using a voltage at a second-type sampling point with relatively high sampling precision, and a voltage at the first-type sampling point is corrected based on the calibration factors to obtain the corrected voltage at the first-type sampling point, which allows the sampling precision at the first-type sampling point to be the same as or similar to that at the second-type sampling point. That is, the sampling precision at the first-type sampling point in the sampling circuit is improved, thereby ensuring relatively high accuracy of the sampling results.

The method for calibrating the sampling circuit according to the embodiments of the present application is first described below.

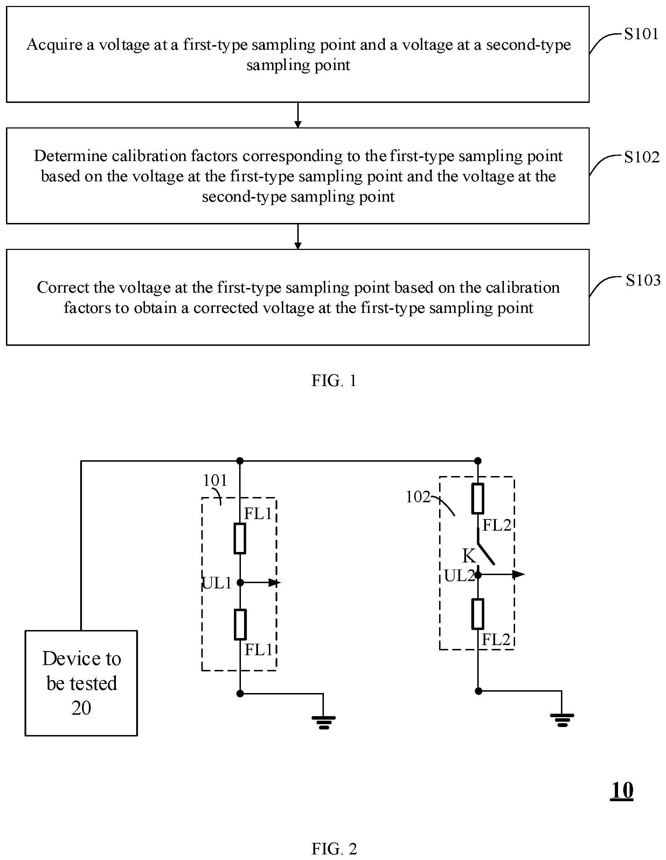

FIG. 1 is a schematic flowchart of a method for calibrating a sampling circuit according to an embodiment of the present application. As shown in FIG. 1, the method for calibrating the sampling circuit according to the embodiment of the present application may include S101 to S103.

In S101, a voltage at a first-type sampling point and a voltage at a second-type sampling point are acquired.

The first-type sampling point and the second-type sampling point may be different sampling points in the sampling circuit.

In S102, calibration factors corresponding to the first-type sampling point are determined based on the voltage at the first-type sampling point and the voltage at the second-type sampling point.

In some embodiments, for example, the sampling precision at the first-type sampling point may be different from that at the second-type sampling point. For example, the sampling precision at the second-type sampling point may be higher than that at the first-type sampling point. Since the precision for the voltage at the second-type sampling point is relatively high, the voltage at the second-type sampling point may be used to correct the voltage at the first-type sampling point. For example, in S202, the calibration factors corresponding to the first-type sampling point may be determined based on the voltage at the first-type sampling point and the voltage at the second-type sampling point.

In S103, the voltage at the first-type sampling point is corrected based on the calibration factors to obtain the corrected voltage at the first-type sampling point.

After the calibration factors corresponding to the first-type sampling point are obtained, the voltage at the first-type sampling point may be corrected based on the calibration factors corresponding to the first-type sampling point to obtain the corrected voltage at the first-type sampling point.

According to the method for calibrating the sampling circuit according to the embodiments of the present application, the calibration factors corresponding to the first-type sampling point are calculated by using the voltage at the second-type sampling point with relatively high sampling precision, and the voltage at the first-type sampling point is corrected based on the calibration factors to obtain the corrected voltage at the first-type sampling point, which allows the sampling precision at the first-type sampling point to be the same as or similar to that at the second-type sampling point. That is, the sampling precision at the first-type sampling point in the sampling circuit is improved, thereby ensuring relatively high accuracy of the sampling results.

For ease of understanding, the method for calibrating the sampling circuit is described below with reference to the circuit structure of the sampling circuit in some application embodiments. It should be noted that, the method for calibrating the sampling circuit in the embodiments of the present application is not limited to being applied to the sampling circuit shown in the following drawings.

FIG. 2 is a schematic diagram of a circuit connection of a sampling circuit according to an embodiment of the present application. As shown in FIG. 1, in some embodiments, the sampling circuit 10 may include a first-type sampling branch 101 and a second-type sampling branch 102. Both the first-type sampling branch 101 and the second-type sampling branch 102 are electrically connected to a device to be tested 20. The first-type sampling branch 101 is provided with a first-type voltage divider module FL1 and a first-type sampling point UL1. The second-type sampling branch 102 is provided with a second-type voltage divider module FL2, a switch module K, and a second-type sampling point UL2. The switch module K is disposed in the second-type sampling branch 102, and sampling is performed at the second-type sampling point UL2 when the switch module K is turned on. In the embodiments of the present application, for example, the device to be tested 20 includes, but is not limited to, a power battery.

Illustratively, the resistance value of the first-type voltage divider module FL1 may be different from that of the second-type voltage divider module FL2. As shown in FIG. 2, since the second-type sampling branch 102 is provided with the switch module K, when the output voltage at the device to be tested 20 is relatively high, the switch module K may be turned off, thereby avoiding damage to devices (such as the second-type voltage divider module FL2) in the second-type sampling branch 102. Therefore, compared with the first-type sampling branch 101, the second-type sampling branch 102 may use a resistor with a relatively small resistance value and relatively high precision, thereby ensuring relatively high sampling precision at the second-type sampling point UL2.

With reference to FIGs. 1 and 2, in S101, for example, the voltage at the first-type sampling point UL1 and the voltage at the second-type sampling point UL2 may be acquired.

Since the precision for the voltage at the second-type sampling point UL2 is relatively high, the voltage at the second-type sampling point UL2 may be used to correct the voltage at the first-type sampling point UL1. For example, in S102, the calibration factors corresponding to the first-type sampling point UL1 may be calculated based on the voltage at the first-type sampling point UL1 and the voltage at the second-type sampling point UL2.

In S103, after the calibration factors corresponding to the first-type sampling point UL1 are obtained, the voltage at the first-type sampling point UL1 may be corrected based on the calibration factors corresponding to the first-type sampling point to obtain the corrected voltage at the first-type sampling point.

According to the method for calibrating the sampling circuit according to the embodiments of the present application, the calibration factors corresponding to the first-type sampling point are calculated by using the voltage at the second-type sampling point with relatively high sampling precision, and the voltage at the first-type sampling point is corrected based on the calibration factors to obtain the corrected voltage at the first-type sampling point, which allows the sampling precision at the first-type sampling point to be the same as or similar to that at the second-type sampling point. That is, the sampling precision at the first-type sampling point in the sampling circuit is improved, thereby ensuring relatively high accuracy of the sampling results.

For ease of understanding, the implementation process of each step is illustrated by way of example below.

According to some embodiments of the present application, optionally, in S102, the calibration factors corresponding to the first-type sampling point are determined based on the voltage at the first-type sampling point and the voltage at the second-type sampling point, and the method may specifically include the following step:

determining the calibration factors corresponding to the first-type sampling point based on voltages at the first-type sampling point at a plurality of moments and voltages at the second-type sampling point at the plurality of moments.

In some embodiments, the calibration factors may include, for example, two or more parameters to be obtained. Therefore, in S102, the calibration factors corresponding to the first-type sampling point may be determined based on the voltages at the first-type sampling point acquired at a plurality of moments (for example, two or more moments) and the voltages at the second-type sampling point acquired at the plurality of moments.

It should be noted that, in some other embodiments of the present application, the calibration factors may further include, for example, a parameter to be obtained. Correspondingly, in S102, the calibration factors corresponding to the first-type sampling point may be determined based on a voltage at the first-type sampling point acquired at a moment and a voltage at the second-type sampling point acquired at the moment, and the present application is not limited thereto.

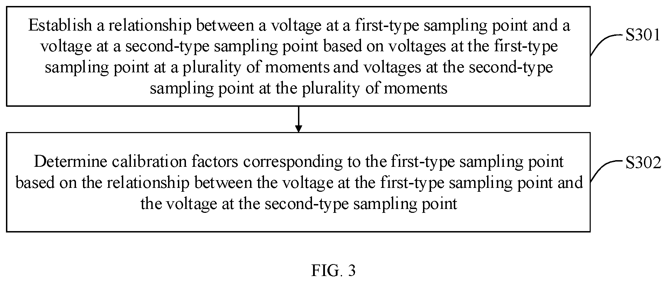

FIG. 3 is a schematic flowchart of S102 in a method for calibrating a sampling circuit according to an embodiment of the present application. As shown in FIG. 3, according to some embodiments of the present application, optionally, in S102, the calibration factors corresponding to the first-type sampling point are determined based on the voltage at the first-type sampling point and the voltage at the second-type sampling point, and the method may specifically include the following steps S301 and S302.

In S301, a relationship between the voltage at the first-type sampling point and the voltage at the second-type sampling point is established based on voltages at the first-type sampling point at a plurality of moments and voltages at the second-type sampling point at the plurality of moments.

In S302, the calibration factors corresponding to the first-type sampling point are determined based on the relationship between the voltage at the first-type sampling point and the voltage at the second-type sampling point.

The plurality of moments may be two or more moments. When the calibration factors corresponding to the first-type sampling point are determined, the relationship between the voltage at the first-type sampling point and the voltage at the second-type sampling point may be first established or determined based on the voltages at the first-type sampling point at the plurality of moments and the voltages at the second-type sampling point at the plurality of moments. Then, after the relationship between the voltage at the first-type sampling point and the voltage at the second-type sampling point is obtained, the calibration factors corresponding to the first-type sampling point can be determined.

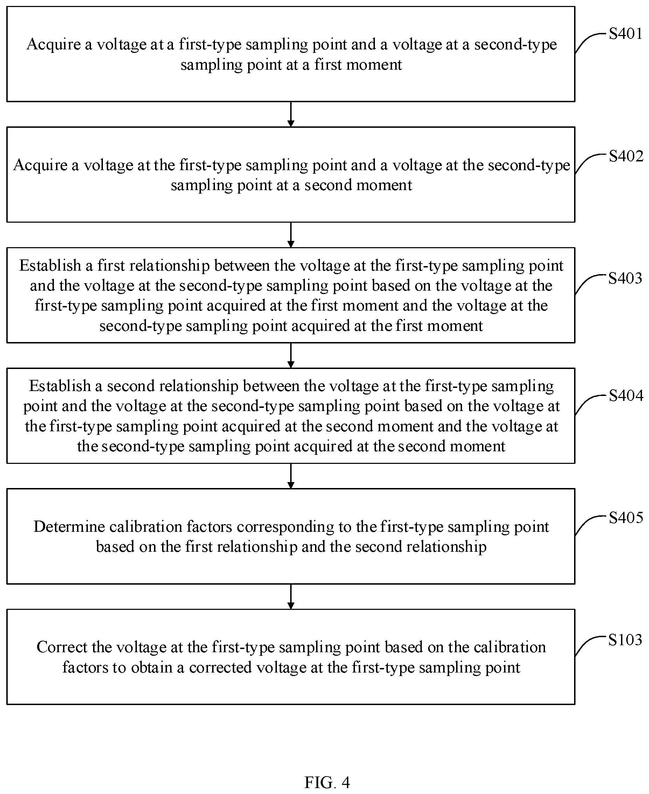

FIG. 4 is another schematic flowchart of a method for calibrating a sampling circuit according to an embodiment of the present application. As shown in FIG. 4, according to some embodiments of the present application, optionally, in S101, the voltage at the first-type sampling point and the voltage at the second-type sampling point are acquired, and the method may specifically include the following steps S401 and S402.

In S401, at a first moment, a voltage at the first-type sampling point and a voltage at the second-type sampling point are acquired.

For example, at a first moment t1, a voltage V11 at the first-type sampling point and a voltage V21 at the second-type sampling point may be acquired.

In S402, at a second moment, a voltage at the first-type sampling point and a voltage at the second-type sampling point are acquired.

For example, at a second moment t2, a voltage V12 at the first-type sampling point and a voltage V22 at the second-type sampling point may be acquired.

The first moment and the second moment are different moments, and a time interval between the first moment and the second moment may be flexibly adjusted based on actual situations. This is not limited in the embodiments of the present application.

Correspondingly, in S102, the calibration factors corresponding to the first-type sampling point are determined based on the voltage at the first-type sampling point and the voltage at the second-type sampling point, and the method may specifically include the following steps S403 to S405.

In S403, a first relationship is established between the voltage at the first-type sampling point and the voltage at the second-type sampling point based on the voltage at the first-type sampling point acquired at the first moment and the voltage at the second-type sampling point acquired at the first moment.

For example, in some examples, the expression of the first relationship between the voltage at the first-type sampling point and the voltage at the second-type sampling point is as follows:

$$V21 = K * V11 + B \qquad (1)$$

The calibration factors corresponding to the first-type sampling point may include a first calibration parameter K and a second calibration parameter B.

In S404, a second relationship is established between the voltage at the first-type sampling point and the voltage at the second-type sampling point based on the voltage at the first-type sampling point acquired at the second moment and the voltage at the second-type sampling point acquired at the second moment.

For example, in some examples, the expression of the second relationship between the voltage at the first-type sampling point and the voltage at the second-type sampling point is as follows:

$$V22 = K * V12 + B \qquad (2)$$

In S405, the calibration factors corresponding to the first-type sampling point are determined based on the first relationship and the second relationship.

For example, the calibration factors K and B corresponding to the first-type sampling point can be calculated by simultaneously solving the expression (1) of the first relationship and the expression (2) of the second relationship described above.

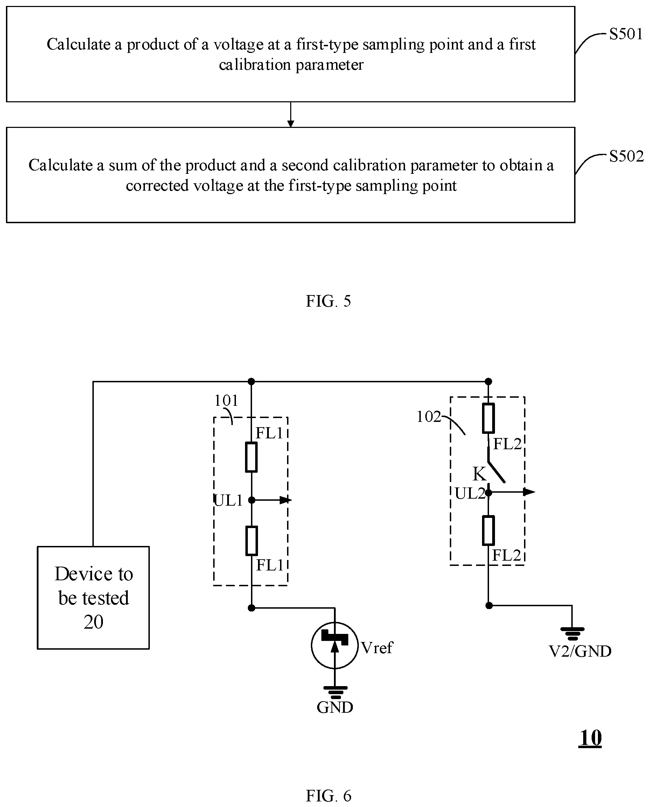

FIG. 5 is a schematic flowchart of S103 in a method for calibrating a sampling circuit according to an embodiment of the present application. As shown in FIG. 5, according to some embodiments of the present application, optionally, in S103, the voltage at the first-type sampling point is corrected based on the calibration factors to obtain the corrected voltage at the first-type sampling point, and the method may include the following steps S501 and S502.

In S501, a product of the voltage at the first-type sampling point and the first calibration parameter is calculated.

In S502, a sum of the product and the second calibration parameter is calculated to obtain the corrected voltage at the first-type sampling point.

For example, in some examples, the voltage at the first-type sampling point may be corrected according to the following expression:

$$V1x' = K * V1x + B \qquad (3)$$

V1x represents the voltage at the first-type sampling point, V1x' represents the corrected voltage at the first-type sampling point, K represents the first calibration parameter, and B represents the second calibration parameter.

According to some embodiments of the present application, optionally, the reference potential of the first-type sampling point may be different from that of the second-type sampling point. For example, the voltage at the first-type sampling point may include a voltage at the first-type sampling point with respect to a first reference potential, and the voltage at the second-type sampling point may include a voltage at the second-type sampling point with respect to a second reference potential. The first reference potential may be different from the second reference potential.

For example, assuming that the actual voltage at the first-type sampling point is +4 V and the voltage at the first reference potential is +2.5 V, the acquired voltage at the first-type sampling point may be a voltage difference value between the actual voltage at the first-type sampling point and the voltage at the first reference potential, such as +1.5 V.

For example, assuming that the actual voltage at the second-type sampling point is +4 V and the voltage at the second reference potential is 0 V, the acquired voltage at the second-type sampling point may be a voltage difference value between the actual voltage at the second-type sampling point and the voltage at the second reference potential, such as +4 V.

In some embodiments, in S403, the first relationship is established between the voltage at the first-type sampling point and the voltage at the second-type sampling point based on the voltage at the first-type sampling point acquired at the first moment and the voltage at the second-type sampling point acquired at the first moment, and the method may include the following step:

establishing the first relationship between the voltage at the first-type sampling point and the voltage at the second-type sampling point based on a voltage difference value between the first reference potential and the second reference potential, and the voltage at the first-type sampling point acquired at the first moment and the voltage at the second-type sampling point acquired at the first moment.

For example, in some examples, the expression of the first relationship between the voltage at the first-type sampling point and the voltage at the second-type sampling point is as follows:

$$V21 = K * V11 + B + \Delta V \qquad (4)$$

The calibration factors corresponding to the first-type sampling point may include a first calibration parameter K and a second calibration parameter B, and $\Delta V$ represents the voltage difference value between the first reference potential and the second reference potential.

In some embodiments, in S404, the second relationship is established between the voltage at the first-type sampling point and the voltage at the second-type sampling point based on the voltage at the first-type sampling point acquired at the second moment and the voltage at the second-type sampling point acquired at the second moment, and the method may include the following step:

establishing the second relationship between the voltage at the first-type sampling point and the voltage at the second-type sampling point based on the voltage difference value between the first reference potential and the second reference potential, and the voltage at the first-type sampling point acquired at the second moment and the voltage at the second-type sampling point acquired at the second moment.

For example, in some examples, the expression of the second relationship between the voltage at the first-type sampling point and the voltage at the second-type sampling point is as follows:

$$V22 = K * V12 + B + \Delta V \qquad (5)$$

The calibration factors corresponding to the first-type sampling point may include a first calibration parameter K and a second calibration parameter B, and $\Delta V$ represents the voltage difference value between the first reference potential and the second reference potential.

In S405, for example, the calibration factors K and B corresponding to the first-type sampling point can be calculated by simultaneously solving the expression (4) of the first relationship and the expression (5) of the second relationship described above.

According to some embodiments of the present application, optionally, in S502, the sum of the product and the second calibration parameter is calculated to obtain the corrected voltage at the first-type sampling point, and the method may include the following step:

calculating the voltage difference value between the first reference potential and the second reference potential, and the sum of the product of the voltage at the first-type sampling point and the first calibration parameter and the second calibration parameter to obtain the corrected voltage at the first-type sampling point.

For example, in some examples, the voltage at the first-type sampling point may be corrected according to the following expression:

$$V1x' = K * V1x + B + \Delta V \qquad (6)$$

V1x represents the voltage at the first-type sampling point, V1x' represents the corrected voltage at the first-type sampling point, K represents the first calibration parameter, B represents the second calibration parameter, and $\Delta V$ represents the voltage difference value between the first reference potential and the second reference potential.

FIG. 6 is another schematic diagram of a circuit connection of a sampling circuit according to an embodiment of the present application. As shown in FIG. 6, according to some embodiments of the present application, optionally, a first-type sampling branch 101 may be electrically connected to a first reference voltage terminal Vref, and a second-type sampling branch 102 may be electrically connected to a second reference voltage terminal V2. The first reference potential may include a potential of the first reference voltage terminal Vref, and the second reference potential may include a potential of the second reference voltage terminal V2. Illustratively, the second reference voltage terminal V2 may be a ground terminal GND.

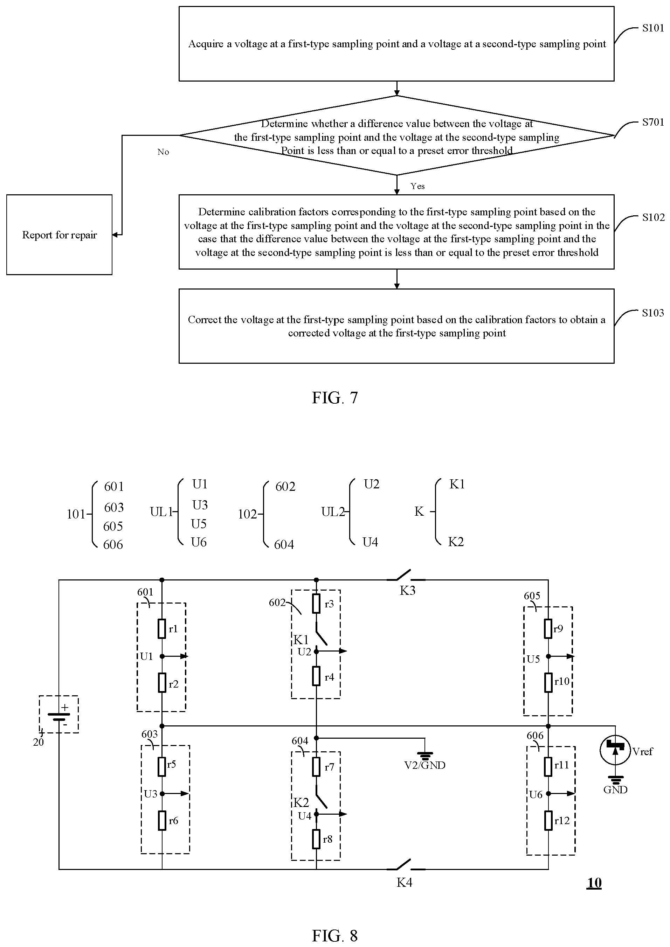

FIG. 7 is yet another schematic flowchart of a method for calibrating a sampling circuit according to an embodiment of the present application. As shown in FIG. 7, according to some embodiments of the present application, optionally, in S102, before the calibration factors corresponding to the first-type sampling point are determined based on the voltage at the first-type sampling point and the voltage at the second-type sampling point, the method for calibrating the sampling circuit may further include the following step.

In S701, it is determined whether a difference value between the voltage at the first-type sampling point and the voltage at the second-type sampling point is less than or equal to a preset error threshold. The preset error threshold may be flexibly adjusted based on actual situations. This is not limited in the embodiments of the present application.

If the difference value between the voltage at the first-type sampling point and the voltage at the second-type sampling point is greater than the preset error threshold, it indicates that a fault occurs in the first-type sampling branch where the first-type sampling point is located, and the fault may be reported for repair.

Correspondingly, in S102, the calibration factors corresponding to the first-type sampling point are determined based on the voltage at the first-type sampling point and the voltage at the second-type sampling point, and the method may specifically include the following step:

determining the calibration factors corresponding to the first-type sampling point based on the voltage at the first-type sampling point and the voltage at the second-type sampling point in the case that the difference value between the voltage at the first-type sampling point and the voltage at the second-type sampling point is less than or equal to the preset error threshold.

FIG. 8 is a schematic diagram of yet another circuit connection of a sampling circuit according to an embodiment of the present application. As shown in FIG. 8, according to some embodiments of the present application, optionally, the first-type sampling branch 101 may include a first sampling branch 601. A first terminal of the first sampling branch 601 is electrically connected to a first electrode of a device to be tested 20, a second terminal of the first sampling branch 601 is electrically connected to the first reference voltage terminal Vref, and a first-type sampling point UL1 may include a first sampling point U1 located on the first sampling branch 601. Illustratively, the first electrode of the device to be tested 20 may be a positive electrode of the device to be tested 20.

The second-type sampling branch 102 may include a second sampling branch 602. A first terminal of the second sampling branch 602 is electrically connected to the first electrode of the device to be tested 20, and a second terminal of the second sampling branch 602 is electrically connected to the second reference voltage terminal V2. The second-type sampling point 602 may include a second sampling point U2 located on the second sampling branch 602. A switch module K may include a first switch module K1, and sampling is performed at the second sampling point U2 when the first switch module K1 is turned on.

In some embodiments, first calibration factors corresponding to the first sampling point may be calculated based on a voltage at the first sampling point and a voltage at the second sampling point.

For example, in some examples, at a first moment t1, a voltage V11a at the first sampling point U1 and a voltage V21a at the second sampling point U2 may be acquired. At a second moment t2, a voltage V12a at the first sampling point U1 and a voltage V22a at the second sampling point U2 are acquired. Next, a first relationship between the voltage at the first sampling point and the voltage at the second sampling point is established based on a voltage difference value between a voltage at the first reference voltage terminal and a voltage at the second reference voltage terminal, and the voltage at the first sampling point and the voltage at the second sampling point acquired at the first moment. A second relationship between the voltage at the first sampling point and the voltage at the second sampling point is established based on the voltage difference value between the voltage at the first reference voltage terminal and the voltage at the second reference voltage terminal, and the voltage at the first sampling point and the voltage at the second sampling point acquired at the second moment.

The expression of the first relationship between the voltage at the first sampling point and the voltage at the second sampling point is as follows:

$$V21a = K1 * V11a + B1 + \Delta V \qquad (7)$$

K1 and B1 are the first calibration factors corresponding to the first sampling point U1, and $\Delta V$ represents the voltage difference value between the voltage at the first reference voltage terminal and the voltage at the second reference voltage terminal.

For example, in some examples, the expression of the second relationship between the voltage at the first sampling point and the voltage at the second sampling point is as follows:

$$V22a = K1 * V12a + B1 + \Delta V \qquad (8)$$

For example, the first calibration factors K1 and B1 corresponding to the first sampling point U1 can be calculated by simultaneously solving the expression (7) of the first relationship and the expression (8) of the second relationship described above.

Correspondingly, in some embodiments, the voltage at the first sampling point may be corrected based on the first calibration factors to obtain the corrected voltage at the first sampling point.

For example, in some examples, the voltage at the first sampling point may be corrected according to the following expression:

$$V1ax' = K1 * V1ax + B1 + \Delta V \qquad (9)$$

V1ax represents the voltage at the first sampling point, and V1ax' represents the corrected voltage at the first sampling point.

Further, as shown in FIG. 8, according to some embodiments of the present application, optionally, the first-type sampling branch 101 may include a third sampling branch 603. A first terminal of the third sampling branch 603 is electrically connected to the first reference voltage terminal Vref, and a second terminal of the third sampling branch 603 is electrically connected to a second electrode of the device to be tested 20. Illustratively, the second electrode of the device to be tested 20 may be a negative electrode of the device to be tested 20. The first-type sampling point UL1 may include a third sampling point U3 located on the third sampling branch 603.

The second-type sampling branch 102 may include a fourth sampling branch 604. A first terminal of the fourth sampling branch 604 is electrically connected to the second reference voltage terminal V2, and a second terminal of the fourth sampling branch 604 is electrically connected to the second electrode of the device to be tested 20. The second-type sampling point UL2 may include a fourth sampling point U4 located on the fourth sampling branch 604. The switch module K may include a second switch module K2, and sampling is performed at the fourth sampling point U4 when the second switch module K2 is turned on.

In some embodiments, second calibration factors corresponding to the third sampling point may be calculated based on a voltage at the third sampling point and a voltage at the fourth sampling point.

For a process of determining the second calibration factors, reference can be made to the above process of determining the calibration factors and the first calibration factors, and the details will not be repeated here.

In some embodiments, the voltage at the third sampling point may be corrected based on the second calibration factors to obtain the corrected voltage at the third sampling point.

For a process of correcting the voltage at the third sampling point, reference can be made to the above process of correcting the voltage at the first-type sampling point and the process of correcting the voltage at the first sampling point, and the details will not be repeated here.

Further, as shown in FIG. 8, according to some embodiments of the present application, optionally, the sampling circuit 10 may further include a third switch module K3, and a first terminal of the third switch module K3 is electrically connected to the first electrode of the device to be tested 20.

The first-type sampling branch 101 may further include a fifth sampling branch 605, a first terminal of the fifth sampling branch 605 is electrically connected to a second terminal of the third switch module K3, a second terminal of the fifth sampling branch 605 is electrically connected to the first reference voltage terminal Vref. The first-type sampling point UL1 may further include a fifth sampling point U5 located on the fifth sampling branch 605.

In some embodiments, third calibration factors corresponding to the fifth sampling point may be calculated based on a voltage at the fifth sampling point and the voltage at the second sampling point.

For a process of determining the third calibration factors, reference can be made to the above process of determining the calibration factors and the first calibration factors, and the details will not be repeated here.

In some embodiments, the voltage at the fifth sampling point may be corrected based on the third calibration factors to obtain the corrected voltage at the fifth sampling point.

For a process of correcting the voltage at the fifth sampling point, reference can be made to the above process of correcting the voltage at the first-type sampling point and the process of correcting the voltage at the first sampling point, and the details will not be repeated here.

Further, as shown in FIG. 8, according to some embodiments of the present application, optionally, the sampling circuit 10 may further include a fourth switch module K4, and a first terminal of the fourth switch module K4 is electrically connected to the second electrode of the device to be tested 20.

The first-type sampling branch 101 may further include a sixth sampling branch 606. A first terminal of the sixth sampling branch 606 is electrically connected to the first reference voltage terminal Vref, and a second terminal of the sixth sampling branch 606 is electrically connected to a second terminal of the fourth switch module K4. The first-type sampling point UL1 may further include a sixth sampling point U6 located on the sixth sampling branch 606.

In some embodiments, fourth calibration factors corresponding to the sixth sampling point may be calculated based on a voltage at the sixth sampling point and the voltage at the fourth sampling point.

For a process of determining the fourth calibration factors, reference can be made to the above process of determining the calibration factors and the first calibration factors, and the details will not be repeated here.

In some embodiments, the voltage at the sixth sampling point may be corrected based on the fourth calibration factors to obtain the corrected voltage at the sixth sampling point.

For a process of correcting the voltage at the sixth sampling point, reference can be made to the above process of correcting the voltage at the first-type sampling point and the process of correcting the voltage at the first sampling point, and the details will not be repeated here.

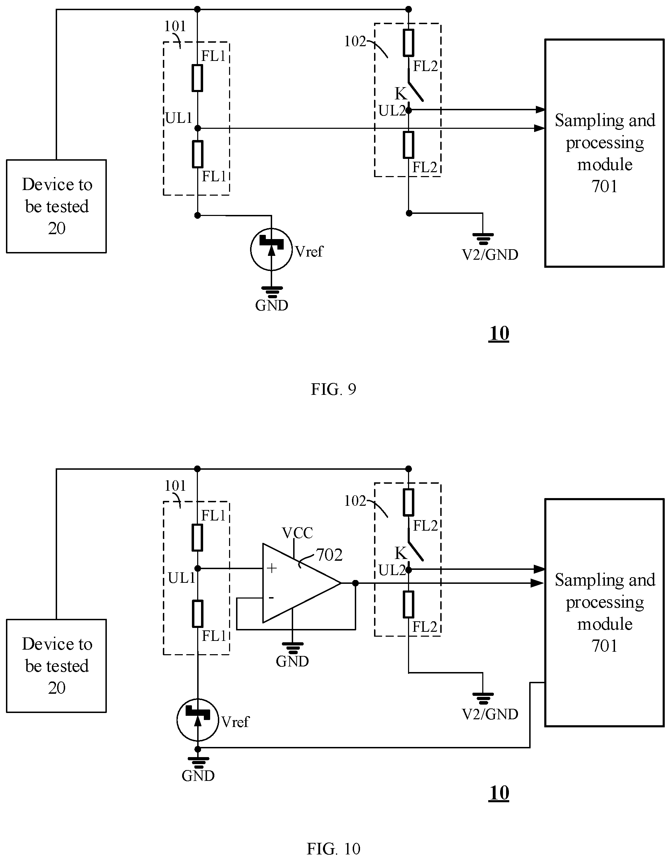

FIG. 9 is a schematic diagram of yet another circuit connection of a sampling circuit according to an embodiment of the present application. As shown in FIG. 9, according to some embodiments of the present application, optionally, the sampling circuit 10 may further include a sampling and processing module 701. The sampling and processing module 701 may be electrically connected to the first-type sampling point UL1 and the second-type sampling point UL2, respectively, the sampling and processing module 701 is configured to acquire a voltage at the first-type sampling point UL1 and a voltage at the second-type sampling point UL2, and correct the voltage at the first-type sampling point UL1 based on calibration factors, and the calibration factors are determined based on the voltage at the first-type sampling point UL1 and the voltage at the second-type sampling point UL2. In some examples, the sampling and processing module 701 may include a sampling chip. The sampling chip is configured to acquire the voltage at the first-type sampling point UL1 and the voltage at the second-type sampling point UL2, and correct the voltage at the first-type sampling point UL1 based on the calibration factors. That is, the sampling chip may be configured not only to acquire the voltage, but also to correct the voltage at the first-type sampling point based on the calibration factors.

In some other examples, the sampling and processing module 701 may include the sampling chip and a processing chip. The sampling chip is electrically connected to the processing chip, and the sampling chip is configured to acquire the voltage at the first-type sampling point UL1 and the voltage at the second-type sampling point UL2. The processing chip is configured to correct the voltage at the first-type sampling point UL1 based on the calibration factors. That is, the sampling chip is only configured to acquire the voltage, and the processing chip is configured to correct the voltage at the first-type sampling point based on the calibration factors.

The voltage at the first reference voltage terminal Vref may be greater than 0 V, and may be less than the maximum value of the sampling range of the sampling and processing module. For example, assuming that the sampling range of the sampling and processing module is 0 to +5 V, the maximum value of the sampling range of the sampling and processing module is +5 V. The voltage at the first reference voltage terminal Vref may be less than +5 V.

With reference to FIGs. 8 and 9, sampling may be performed at the first-type sampling point UL1 (such as the first sampling point U1, the third sampling point U3, the fifth sampling point U5, and the sixth sampling point U6) with respect to the first reference voltage terminal Vref. The voltage Vf at the first reference voltage terminal Vref may be greater than 0 V, and may be less than the maximum value Max-AD of the sampling range of the sampling and processing module. In this way, positive and negative voltage sampling may be performed at the first-type sampling point UL1. That is, when the sampling input is within a range of 0 to Vf, the voltage at the first-type sampling point UL1 is a negative voltage, and when the sampling input is within a range of Vf to Max-AD, the voltage at the first-type sampling point UL1 is a positive voltage. By combining the sampling points, a required relative voltage may be converted. For example, an output voltage at the device to be tested 20 may be calculated based on a sum of the voltage at the first sampling point U1 and the voltage at the third sampling point U3.

As shown in FIG. 8, according to some embodiments of the present application, optionally, the first sampling branch 601 may include a first voltage divider module r1, a second voltage divider module r2, and the first sampling point U1. Illustratively, both the first voltage divider module r1 and the second voltage divider module r2 may include resistors.

A first terminal of the first voltage divider module r1 is electrically connected to the first electrode of the device to be tested 20, and a second terminal of the first voltage divider module r1 is electrically connected to the first sampling point U1.

A first terminal of the second voltage divider module r2 is electrically connected to the first sampling point U1, and a second terminal of the second voltage divider module r2 is electrically connected to the first reference voltage terminal Vref.

As shown in FIG. 8, the voltage output by the first electrode of the device to be tested 20 may be delivered to the first reference voltage terminal Vref via the first sampling branch 601, and then delivered to the ground terminal GND. Therefore, when the voltage output by the first electrode of the device to be tested 20 is relatively high, the devices in the first sampling branch 601 may be damaged. To meet a voltage withstand requirement of the sampling circuit and protect the sampling circuit, in some embodiments, at least one of the first voltage divider module r1 and the second voltage divider module r2 may be a resistor with a relatively large resistance value.

For example, in some examples, a sum of a resistance value of the first voltage divider module r1 and a resistance value of the second voltage divider module r2 may be in a value range of 25 to 30 megaohms.

In this way, since the first voltage divider module r1 and/or the second voltage divider module r2 are/is a resistor with a relatively large resistance value, even when the voltage output by the device to be tested 20 is relatively high, the voltage withstand requirement of the sampling circuit can still be met.

As shown in FIG. 8, according to some embodiments of the present application, optionally, the second sampling branch 602 includes a third voltage divider module r3, a fourth voltage divider module r4, the first switch module K1, and the second sampling point U2. The third sampling branch 603 includes a fifth voltage divider module r5, a sixth voltage divider module r6, and the third sampling point U3. The fourth sampling branch 604 includes a seventh voltage divider module r7, an eighth voltage divider module r8, the second switch module K2, and the fourth sampling point U4. The fifth sampling branch 605 includes a ninth voltage divider module r9, a tenth voltage divider module r10, and the fifth sampling point U5. The sixth sampling branch 606 includes an eleventh voltage divider module r11, a twelfth voltage divider module r12, and the sixth sampling point U6.

A first terminal of the third voltage divider module r3 is electrically connected to the first electrode of the device to be tested 20, and a second terminal of the third voltage divider module r3 is electrically connected to a first terminal of the first switch module K1.

A second terminal of the first switch module K1 is electrically connected to the second sampling point U2. A first terminal of the fourth voltage divider module r4 is electrically connected to the second sampling point U2, and a second terminal of the fourth voltage divider module r4 is electrically connected to the second reference voltage terminal V2.

A first terminal of the fifth voltage divider module r5 is electrically connected to the first reference voltage terminal Vref, and a second terminal of the fifth voltage divider module r5 is electrically connected to the third sampling point U3. A first terminal of the sixth voltage divider module r6 is electrically connected to the third sampling point U3, and a second terminal of the sixth voltage divider module r6 is electrically connected to the second electrode of the device to be tested 20.

A first terminal of the seventh voltage divider module r7 is electrically connected to the second reference voltage terminal V2, and a second terminal of the seventh voltage divider module r7 is electrically connected to a first terminal of the second switch module K2. A second terminal of the second switch module K2 is electrically connected to the fourth sampling point U4. A first terminal of the eighth voltage divider module r8 is electrically connected to the fourth sampling point U4, and a second terminal of the eighth voltage divider module r8 is electrically connected to the second electrode of the device to be tested 20.

A first terminal of the ninth voltage divider module r9 is electrically connected to the second terminal of the third switch module K3, and a second terminal of the ninth voltage divider module r9 is electrically connected to the fifth sampling point U5. A first terminal of the tenth voltage divider module r10 is electrically connected to the fifth sampling point U5, and a second terminal of the tenth voltage divider module r10 is electrically connected to the first reference voltage terminal Vref.

A first terminal of the eleventh voltage divider module r11 is electrically connected to the first reference voltage terminal Vref, and a second terminal of the eleventh voltage divider module r11 is electrically connected to the sixth sampling point U6. A first terminal of the twelfth voltage divider module r12 is electrically connected to the sixth sampling point U6, and a second terminal of the twelfth voltage divider module r12 is electrically connected to the second electrode of the device to be tested 20.

FIG. 10 is a schematic diagram of yet another circuit connection of a sampling circuit according to an embodiment of the present application. As shown in FIG. 10, according to some embodiments of the present application, optionally, the sampling circuit 10 may further include the sampling and processing module 701 and the follower 702.

A first input terminal of the follower 702 is electrically connected to the first-type sampling point UL1. With reference to FIGs. 6 and 10, the first-type sampling point UL1 includes, but is not limited to, the first sampling point U1, the third sampling point U3, the fifth sampling point U5, and the sixth sampling point U6. That is, the first sampling point U1, the third sampling point U3, the fifth sampling point U5, and the sixth sampling point U6 may all be electrically connected to the first input terminal of the follower 702.

A second input terminal of the follower 702 may be electrically connected to an output terminal of the follower 702, a first power input terminal of the follower 702 is electrically connected to a positive power voltage signal terminal VCC, a second power input terminal of the follower 702 is electrically connected to the ground terminal GND, and the output terminal of the follower 702 is electrically connected to a voltage acquisition terminal of the sampling and processing module 701.

A potential reference terminal of the sampling and processing module 701 is electrically connected to the ground terminal GND, and the sampling and processing module 701 may be configured to acquire the voltage at the first-type sampling point UL1.

The internal resistance of the sampling and processing module 701 is relatively large. Therefore, when the resistance values of the voltage divider modules in the first-type sampling branch 101 are relatively small, the sampling precision at the first-type sampling point UL1 is relatively less affected by the internal resistance of the sampling and processing module 701, and the sampling precision at the first-type sampling point UL1 is relatively high. When the resistance values of the voltage divider modules (such as the first voltage divider module r1 and the second voltage divider module r2 in the first sampling branch 601) in the first-type sampling branch 101 are relatively large, the difference between the resistance values of the voltage divider modules and an internal resistance value of the sampling and processing module 701 is relatively small, the internal resistance of the sampling and processing module 701 participates in voltage division, such that the sampling precision at the first-type sampling point UL1 is relatively low.

Since the follower 702 has the characteristics of high-impedance input and high-impedance output, adding the follower 702 between the first-type sampling point UL1 and the sampling and processing module 701 is equivalent to isolating the voltage divider modules in the first-type sampling branch 101 from the internal resistance of the sampling and processing module 701. This reduces the influence of the internal resistance of the sampling and processing module 701 on the sampling precision at the first-type sampling point UL1, thereby ensuring that the sampling precision at the first-type sampling point UL1 remains relatively high in the case that the resistance values of the voltage divider modules in the first-type sampling branch 101 are large.

The follower 702 also has an amplification function; that is, the follower can amplify the voltage at the first-type sampling point UL1 by a preset multiple before delivering it to the sampling and processing module 701. The preset multiple may be flexibly adjusted based on actual situations. This is not limited in the embodiments of the present application.

For example, in some embodiments, the follower 702 may perform amplification by a preset multiple of 1:1. In some other embodiments, the follower 702 may also perform amplification by a preset multiple of 1:n, where n is greater than 1.

As such, in the case that the resistance values of the voltage divider modules in the first-type sampling branch 101 are relatively large, the follower is added to amplify the acquired voltage value at the first-type sampling point UL1, thereby further improving the sampling precision at the first-type sampling point UL1.

Based on the method for calibrating the sampling circuit according to the above embodiments, the present application further provides a sampling circuit.

As shown in FIG. 9, the sampling circuit 10 according to the embodiments of the present application may include the first-type sampling branch 101, the second-type sampling branch 102, and the sampling and processing module 701. The first-type sampling branch 101 is electrically connected to the device to be tested 20, and the first-type sampling branch 101 is provided with a first-type voltage divider module FL1 and the first-type sampling point UL1. The second-type sampling branch 102 is electrically connected to the device to be tested 20, and the second-type sampling branch 102 is provided with a second-type voltage divider module FL2, the switch module K, and the second-type sampling point UL2. The sampling and processing module 701 is electrically connected to the first-type sampling point UL1 and the second-type sampling point UL2, respectively, the sampling and processing module 701 is configured to correct the voltage at the first-type sampling point UL1 based on the calibration factors, and the calibration factors are determined based on the voltage at the first-type sampling point UL1 and the voltage at the second-type sampling point UL2.

The circuit structure of the sampling circuit has been described in detail above, and the details will not be repeated here.

According to the sampling circuit according to the embodiments of the present application, the calibration factors corresponding to the first-type sampling point are calculated by using the voltage at the second-type sampling point with relatively high sampling precision, and the voltage at the first-type sampling point is corrected based on the calibration factors to obtain the corrected voltage at the first-type sampling point, which allows the sampling precision at the first-type sampling point to be the same as or similar to that at the second-type sampling point. That is, the sampling precision at the first-type sampling point in the sampling circuit is improved, thereby ensuring relatively high accuracy of the sampling results.

According to some embodiments of the present application, optionally, the sampling and processing module 701 may include a sampling chip. The sampling chip is configured to acquire the voltage at the first-type sampling point UL1 and the voltage at the second-type sampling point UL2, and correct the voltage at the first-type sampling point UL1 based on the calibration factors. That is, the sampling chip may be configured not only to acquire the voltage, but also to correct the voltage at the first-type sampling point based on the calibration factors.

According to some embodiments of the present application, optionally, the sampling and processing module 701 may include the sampling chip and a processing chip. The sampling chip is electrically connected to the processing chip, and the sampling chip is configured to acquire the voltage at the first-type sampling point UL1 and the voltage at the second-type sampling point UL2. The processing chip is configured to correct the voltage at the first-type sampling point UL1 based on the calibration factors. That is, the sampling chip is only configured to acquire the voltage, and the processing chip is configured to correct the voltage at the first-type sampling point based on the calibration factors.

According to some embodiments of the present application, optionally, the first-type sampling branch is electrically connected to a first reference voltage terminal, and the second-type sampling branch is electrically connected to a second reference voltage terminal; the voltage at the first-type sampling point includes a voltage at the first-type sampling point with respect to the first reference voltage terminal, and the voltage at the second-type sampling point includes a voltage at the second-type sampling point with respect to the second reference voltage terminal.

According to some embodiments of the present application, optionally, the first-type sampling branch includes a first sampling branch, a first terminal of the first sampling branch is electrically connected to a first electrode of the device to be tested, a second terminal of the first sampling branch is electrically connected to the first reference voltage terminal, and the first-type sampling point includes a first sampling point located on the first sampling branch; the second-type sampling branch includes a second sampling branch, a first terminal of the second sampling branch is electrically connected to the first electrode of the device to be tested, a second terminal of the second sampling branch is electrically connected to the second reference voltage terminal, the second-type sampling point includes a second sampling point located on the second sampling branch, the switch module includes a first switch module, and sampling is performed at the second sampling point when the first switch module is turned on.

According to some embodiments of the present application, optionally, the first-type sampling branch includes a third sampling branch, a first terminal of the third sampling branch is electrically connected to the first reference voltage terminal, a second terminal of the third sampling branch is electrically connected to a second electrode of the device to be tested, and the first-type sampling point includes a third sampling point located on the third sampling branch; the second-type sampling branch includes a fourth sampling branch, a first terminal of the fourth sampling branch is electrically connected to the second reference voltage terminal, a second terminal of the fourth sampling branch is electrically connected to the second electrode of the device to be tested, the second-type sampling point includes a fourth sampling point located on the fourth sampling branch, the switch module includes a second switch module, and sampling is performed at the fourth sampling point when the second switch module is turned on.

According to some embodiments of the present application, optionally, the sampling circuit further includes a third switch module, and a first terminal of the third switch module is electrically connected to the first electrode of the device to be tested; the first-type sampling branch further includes a fifth sampling branch, a first terminal of the fifth sampling branch is electrically connected to a second terminal of the third switch module, a second terminal of the fifth sampling branch is electrically connected to the first reference voltage terminal, and the first-type sampling point further includes a fifth sampling point located on the fifth sampling branch.

According to some embodiments of the present application, optionally, the sampling circuit further includes a fourth switch module, and a first terminal of the fourth switch module is electrically connected to the second electrode of the device to be tested; the first-type sampling branch further includes a sixth sampling branch, a first terminal of the sixth sampling branch is electrically connected to the first reference voltage terminal, a second terminal of the sixth sampling branch is electrically connected to a second terminal of the fourth switch module, and the first-type sampling point further includes a sixth sampling point located on the sixth sampling branch.

The circuit structure of the sampling circuit has been described in detail above, and the details will not be repeated here.

According to some embodiments of the present application, optionally, a voltage at the first reference voltage terminal is greater than 0 V and less than the maximum value of a sampling range of a sampling chip.

According to some embodiments of the present application, optionally, the first sampling branch includes a first voltage divider module, a second voltage divider module, and the first sampling point; a first terminal of the first voltage divider module is electrically connected to the first electrode of the device to be tested, and a second terminal of the first voltage divider module is electrically connected to the first sampling point; a first terminal of the second voltage divider module is electrically connected to the first sampling point, and a second terminal of the second voltage divider module is electrically connected to the first reference voltage terminal; a sum of a resistance value of the first voltage divider module and a resistance value of the second voltage divider module is in a value range of 25 to 30 megaohms.

As shown in FIG. 8, according to some embodiments of the present application, optionally, the second sampling branch 602 includes a third voltage divider module r3, a fourth voltage divider module r4, the first switch module K1, and the second sampling point U2. The third sampling branch 603 includes a fifth voltage divider module r5, a sixth voltage divider module r6, and the third sampling point U3. The fourth sampling branch 604 includes a seventh voltage divider module r7, an eighth voltage divider module r8, the second switch module K2, and the fourth sampling point U4. The fifth sampling branch 605 includes a ninth voltage divider module r9, a tenth voltage divider module r10, and the fifth sampling point U5. The sixth sampling branch 606 includes an eleventh voltage divider module r11, a twelfth voltage divider module r12, and the sixth sampling point U6.

A first terminal of the third voltage divider module r3 is electrically connected to the first electrode of the device to be tested 20, and a second terminal of the third voltage divider module r3 is electrically connected to a first terminal of the first switch module K1.

A second terminal of the first switch module K1 is electrically connected to the second sampling point U2. A first terminal of the fourth voltage divider module r4 is electrically connected to the second sampling point U2, and a second terminal of the fourth voltage divider module r4 is electrically connected to the second reference voltage terminal V2.

A first terminal of the fifth voltage divider module r5 is electrically connected to the first reference voltage terminal Vref, and a second terminal of the fifth voltage divider module r5 is electrically connected to the third sampling point U3. A first terminal of the sixth voltage divider module r6 is electrically connected to the third sampling point U3, and a second terminal of the sixth voltage divider module r6 is electrically connected to the second electrode of the device to be tested 20.

A first terminal of the seventh voltage divider module r7 is electrically connected to the second reference voltage terminal V2, and a second terminal of the seventh voltage divider module r7 is electrically connected to a first terminal of the second switch module K2. A second terminal of the second switch module K2 is electrically connected to the fourth sampling point U4. A first terminal of the eighth voltage divider module r8 is electrically connected to the fourth sampling point U4, and a second terminal of the eighth voltage divider module r8 is electrically connected to the second electrode of the device to be tested 20.

A first terminal of the ninth voltage divider module r9 is electrically connected to the second terminal of the third switch module K3, and a second terminal of the ninth voltage divider module r9 is electrically connected to the fifth sampling point U5. A first terminal of the tenth voltage divider module r10 is electrically connected to the fifth sampling point U5, and a second terminal of the tenth voltage divider module r10 is electrically connected to the first reference voltage terminal Vref.

A first terminal of the eleventh voltage divider module r11 is electrically connected to the first reference voltage terminal Vref, and a second terminal of the eleventh voltage divider module r11 is electrically connected to the sixth sampling point U6. A first terminal of the twelfth voltage divider module r12 is electrically connected to the sixth sampling point U6, and a second terminal of the twelfth voltage divider module r12 is electrically connected to the second electrode of the device to be tested 20.

According to some embodiments of the present application, optionally, the sampling circuit further includes a follower; a first input terminal of the follower is electrically connected to the first-type sampling point, a second input terminal of the follower is electrically connected to an output terminal of the follower, a first power input terminal of the follower is electrically connected to a positive power voltage signal terminal, a second power input terminal of the follower is electrically connected to a ground terminal, and the output terminal of the follower is electrically connected to a voltage acquisition terminal of the sampling chip; a potential reference terminal of the sampling chip is electrically connected to the ground terminal.

Based on the sampling circuit 10 according to the above embodiments, the present application further provides a battery management system (BMS). The battery management system according to the embodiments of the present application may include the sampling circuit 10 according to the above embodiments.

According to the battery management system according to the embodiments of the present application, the calibration factors corresponding to the first-type sampling point are calculated by using the voltage at the second-type sampling point with relatively high sampling precision, and the voltage at the first-type sampling point is corrected based on the calibration factors to obtain the corrected voltage at the first-type sampling point, which allows the sampling precision at the first-type sampling point to be the same as or similar to that at the second-type sampling point. That is, the sampling precision at the first-type sampling point in the sampling circuit is improved, thereby ensuring relatively high accuracy of the sampling results.

Based on the sampling circuit 10 or the battery management system according to the above embodiments, the present application further provides an electric device. The electric device includes the sampling circuit 10 according to the above embodiments or the battery management system according to the above embodiments. In some specific embodiments, optionally, the electric device may be a vehicle. The vehicle may be a fuel vehicle, a gas vehicle, or a new energy vehicle. The new energy vehicle may be a pure electric vehicle, a hybrid vehicle, an extended-range vehicle, or the like.

Although the present application has been described with reference to preferred embodiments, various modifications can be made and components herein can be replaced with equivalents without departing from the scope of the present application. In particular, the technical features mentioned in the embodiments may be combined in any manner as long as there are no structural conflicts. The present application is not limited to the specific embodiments disclosed herein, but encompasses all technical solutions falling within the scope of the claims.

**Claims**

1.  A method for calibrating a sampling circuit, comprising:

    acquiring a voltage at a first-type sampling point and a voltage at a second-type sampling point;
    determining calibration factors corresponding to the first-type sampling point based on the voltage at the first-type sampling point and the voltage at the second-type sampling point; and
    correcting the voltage at the first-type sampling point based on the calibration factors to obtain a corrected voltage at the first-type sampling point.

2.  The calibration method according to claim 1, wherein determining the calibration factors corresponding to the first-type sampling point based on the voltage at the first-type sampling point and the voltage at the second-type sampling point comprises:
    determining the calibration factors corresponding to the first-type sampling point based on voltages at the first-type sampling point at a plurality of moments and voltages at the second-type sampling point at the plurality of moments.

3.  The calibration method according to claim 1 or 2, wherein determining the calibration factors corresponding to the first-type sampling point based on the voltage at the first-type sampling point and the voltage at the second-type sampling point comprises:

    establishing a relationship between the voltage at the first-type sampling point and the voltage at the second-type sampling point based on the voltages at the first-type sampling point at the plurality of moments and the voltages at the second-type sampling point at the plurality of moments; and
    determining the calibration factors corresponding to the first-type sampling point based on the relationship between the voltage at the first-type sampling point and the voltage at the second-type sampling point.

4.  The calibration method according to any one of claims 1 to 3, wherein
    determining the calibration factors corresponding to the first-type sampling point based on the voltage at the first-type sampling point and the voltage at the second-type sampling point comprises:

    establishing a first relationship between the voltage at the first-type sampling point and the voltage at the second-type sampling point based on a voltage at the first-type sampling point acquired at a first moment and a voltage at the second-type sampling point acquired at the first moment;
    establishing a second relationship between the voltage at the first-type sampling point and the voltage at the second-type sampling point based on a voltage at the first-type sampling point acquired at a second moment and a voltage at the second-type sampling point acquired at the second moment; and
    determining the calibration factors corresponding to the first-type sampling point based on the first relationship and the second relationship.

5.  The calibration method according to claim 4, wherein

    the voltage at the first-type sampling point comprises a voltage at the first-type sampling point with respect to a first reference potential, and the voltage at the second-type sampling point comprises a voltage at the second-type sampling point with respect to a second reference potential;
    establishing the first relationship between the voltage at the first-type sampling point and the voltage at the second-type sampling point based on the voltage at the first-type sampling point acquired at the first moment and the voltage at the second-type sampling point acquired at the first moment comprises:
    establishing the first relationship between the voltage at the first-type sampling point and the voltage at the second-type sampling point based on a voltage difference value between the first reference potential and the second reference potential, and the voltage at the first-type sampling point acquired at the first moment and the voltage at the second-type sampling point acquired at the first moment.

6. The calibration method according to claim 5, wherein establishing the second relationship between the voltage at the first-type sampling point and the voltage at the second-type sampling point based on the voltage at the first-type sampling point acquired at the second moment and the voltage at the second-type sampling point acquired at the second moment comprises:
   establishing the second relationship between the voltage at the first-type sampling point and the voltage at the second-type sampling point based on the voltage difference value between the first reference potential and the second reference potential, and the voltage at the first-type sampling point acquired at the second moment and the voltage at the second-type sampling point acquired at the second moment.

7. The calibration method according to any one of claims 1 to 6, wherein the calibration factors comprise a first calibration parameter and a second calibration parameter;
   correcting the voltage at the first-type sampling point based on the calibration factors to obtain the corrected voltage at the first-type sampling point comprises:

   calculating a product of the voltage at the first-type sampling point and the first calibration parameter; and
   calculating a sum of the product and the second calibration parameter to obtain the corrected voltage at the first-type sampling point.

8. The calibration method according to claim 7, wherein the voltage at the first-type sampling point comprises the voltage at the first-type sampling point with respect to the first reference potential, and the voltage at the second-type sampling point comprises the voltage at the second-type sampling point with respect to the second reference potential;
   calculating the sum of the product and the second calibration parameter to obtain the corrected voltage at the first-type sampling point comprises:
   calculating the voltage difference value between the first reference potential and the second reference potential, and the sum of the product and the second calibration parameter to obtain the corrected voltage at the first-type sampling point.

9. A sampling circuit, comprising:

a first-type sampling branch, wherein the first-type sampling branch is electrically connected to a device to be tested, and the first-type sampling branch is provided with a first-type voltage divider module and a first-type sampling point;
a second-type sampling branch, wherein the second-type sampling branch is electrically connected to the device to be tested, and the second-type sampling branch is provided with a second-type voltage divider module, a switch module, and a second-type sampling point; and
a sampling and processing module, wherein the sampling and processing module is electrically connected to the first-type sampling point and the second-type sampling point, respectively, the sampling and processing module is configured to correct a voltage at the first-type sampling point based on calibration factors, and the calibration factors are determined based on the voltage at the first-type sampling point and a voltage at the second-type sampling point.

10. The sampling circuit according to claim 9, wherein the first-type sampling branch is electrically connected to a first reference voltage terminal, and the second-type sampling branch is electrically connected to a second reference voltage terminal;
    the voltage at the first-type sampling point comprises a voltage at the first-type sampling point with respect to the first reference voltage terminal, and the voltage at the second-type sampling point comprises a voltage at the second-type sampling point with respect to the second reference voltage terminal.

11. The sampling circuit according to claim 9 or 10, wherein the first-type sampling branch comprises a first sampling branch, a first terminal of the first sampling branch is electrically connected to a first electrode of the device to be tested, a second terminal of the first sampling branch is electrically connected to the first reference voltage terminal, and the first-type sampling point comprises a first sampling point located on the first sampling branch;
    the second-type sampling branch comprises a second sampling branch, a first terminal of the second sampling branch is electrically connected to the first electrode of the device to be tested, a second terminal of the second sampling branch is electrically connected to the second reference voltage terminal, the second-type sampling point comprises a second sampling point located on the second sampling branch, the switch module comprises a first switch module, and sampling is performed at the second sampling point when the first switch module is turned on.

12. The sampling circuit according to any one of claims 9 to 11, wherein the first-type sampling branch comprises a third sampling branch, a first terminal of the third sampling branch is electrically connected to the first reference voltage terminal, a second terminal of the third sampling branch is electrically connected to a second electrode of the device to be tested, and the first-type sampling point comprises a third sampling point located on the third sampling branch;

the second-type sampling branch comprises a fourth sampling branch, a first terminal of the fourth sampling branch is electrically connected to the second reference voltage terminal, a second terminal of the fourth sampling branch is electrically connected to the second electrode of the device to be tested, the second-type sampling point comprises a fourth sampling point located on the fourth sampling branch, the switch module comprises a second switch module, and sampling is performed at the fourth sampling point when the second switch module is turned on.

13. The sampling circuit according to any one of claims 9 to 12, wherein the sampling circuit further comprises a third switch module, and a first terminal of the third switch module is electrically connected to the first electrode of the device to be tested;

the first-type sampling branch further comprises a fifth sampling branch, a first terminal of the fifth sampling branch is electrically connected to a second terminal of the third switch module, a second terminal of the fifth sampling branch is electrically connected to the first reference voltage terminal, and the first-type sampling point further comprises a fifth sampling point located on the fifth sampling branch.

14. The sampling circuit according to any one of claims 9 to 13, wherein the sampling circuit further comprises a fourth switch module, and a first terminal of the fourth switch module is electrically connected to the second electrode of the device to be tested;

the first-type sampling branch further comprises a sixth sampling branch, a first terminal of the sixth sampling branch is electrically connected to the first reference voltage terminal, a second terminal of the sixth sampling branch is electrically connected to a second terminal of the fourth switch module, and the first-type sampling point further comprises a sixth sampling point located on the sixth sampling branch.

15. The sampling circuit according to any one of claims 9 to 14, wherein

a voltage at the first reference voltage terminal is greater than 0 V and less than a maximum value of a sampling range of a sampling chip.

16. The sampling circuit according to any one of claims 9 to 15, wherein the first sampling branch comprises a first voltage divider module, a second voltage divider module, and the first sampling point;

a first terminal of the first voltage divider module is electrically connected to the first electrode of the device to be tested, and a second terminal of the first voltage divider module is electrically connected to the first sampling point;

a first terminal of the second voltage divider module is electrically connected to the first sampling point, and a second terminal of the second voltage divider module is electrically connected to the first reference voltage terminal;

a sum of a resistance value of the first voltage divider module and a resistance value of the second voltage divider module is in a value range of 25 to 30 megaohms.

17. The sampling circuit according to any of claims 9 to 16, wherein the sampling circuit further comprises a follower;

a first input terminal of the follower is electrically connected to the first-type sampling point, a second input terminal of the follower is electrically connected to an output terminal of the follower, a first power input terminal of the follower is electrically connected to a positive power voltage signal terminal, a second power input terminal of the follower is electrically connected to a ground terminal, and the output terminal of the follower is electrically connected to a voltage acquisition terminal of the sampling chip;

a potential reference terminal of the sampling chip is electrically connected to the ground terminal.

18. A battery management system, comprising the sampling circuit according to any one of claims 9 to 17.

19. An electric device, comprising the battery management system according to claim 18.

Acquire a voltage at a first-type sampling point and a voltage at a second-type sampling point ⌐S101

Determine calibration factors corresponding to the first-type sampling point based on the voltage at the first-type sampling point and the voltage at the second-type sampling point ⌐S102

Correct the voltage at the first-type sampling point based on the calibration factors to obtain a corrected voltage at the first-type sampling point ⌐S103

FIG. 1

101

FL1

UL1

FL1

Device to be tested 20

102

FL2

K

UL2

FL2

10

FIG. 2

Establish a relationship between a voltage at a first-type sampling point and a voltage at a second-type sampling point based on voltages at the first-type sampling point at a plurality of moments and voltages at the second-type sampling point at the plurality of moments — S301

Determine calibration factors corresponding to the first-type sampling point based on the relationship between the voltage at the first-type sampling point and the voltage at the second-type sampling point — S302

FIG. 3

Acquire a voltage at a first-type sampling point and a voltage at a second-type sampling point at a first moment ⟋⎯S401

Acquire a voltage at the first-type sampling point and a voltage at the second-type sampling point at a second moment ⟋⎯S402

Establish a first relationship between the voltage at the first-type sampling point and the voltage at the second-type sampling point based on the voltage at the first-type sampling point acquired at the first moment and the voltage at the second-type sampling point acquired at the first moment ⟋⎯S403

Establish a second relationship between the voltage at the first-type sampling point and the voltage at the second-type sampling point based on the voltage at the first-type sampling point acquired at the second moment and the voltage at the second-type sampling point acquired at the second moment ⟋⎯S404

Determine calibration factors corresponding to the first-type sampling point based on the first relationship and the second relationship ⟋⎯S405

Correct the voltage at the first-type sampling point based on the calibration factors to obtain a corrected voltage at the first-type sampling point ⟋⎯S103

FIG. 4

```
┌────────────────────────────────────────────────────────────────┐
│                                                                  │
│   Calculate a product of a voltage at a first-type sampling      │──S501
│   point and a first calibration parameter                        │
│                                                                  │
└────────────────────────────────────────────────────────────────┘
                                │
                                ▼
┌────────────────────────────────────────────────────────────────┐
│                                                                  │
│   Calculate a sum of the product and a second calibration        │──S502
│   parameter to obtain a corrected voltage at the first-type      │
│   sampling point                                                 │
│                                                                  │
└────────────────────────────────────────────────────────────────┘
```

FIG. 5

FIG. 6

Acquire a voltage at a first-type sampling point and a voltage at a second-type sampling point — S101

Determine whether a difference value between the voltage at the first-type sampling point and the voltage at the second-type sampling Point is less than or equal to a preset error threshold — S701

No

Yes

Report for repair

Determine calibration factors corresponding to the first-type sampling point based on the voltage at the first-type sampling point and the voltage at the second-type sampling point in the case that the difference value between the voltage at the first-type sampling point and the voltage at the second-type sampling point is less than or equal to the preset error threshold — S102

Correct the voltage at the first-type sampling point based on the calibration factors to obtain a corrected voltage at the first-type sampling point — S103

FIG. 7

$$101 - \begin{cases} 601 \\ 603 \\ 605 \\ 606 \end{cases} \quad UL1 - \begin{cases} U1 \\ U3 \\ U5 \\ U6 \end{cases} \quad 102 - \begin{cases} 602 \\ 604 \end{cases} \quad UL2 - \begin{cases} U2 \\ U4 \end{cases} \quad K - \begin{cases} K1 \\ K2 \end{cases}$$

FIG. 8

FIG. 9

FIG. 10

## INTERNATIONAL SEARCH REPORT

| International application No. |
| --- |
| **PCT/CN2024/109465** |

**A. CLASSIFICATION OF SUBJECT MATTER**

H03M1/10(2006.01)i; G01R35/00(2006.01)i

According to International Patent Classification (IPC) or to both national classification and IPC

**B. FIELDS SEARCHED**

Minimum documentation searched (classification system followed by classification symbols)

IPC:H03M、G01R

Documentation searched other than minimum documentation to the extent that such documents are included in the fields searched

Electronic data base consulted during the international search (name of data base and, where practicable, search terms used)

CNTXT, ENTXTC, ENTXT, VEN, CNKI, IEEE: 基准, 标准, 参考, 电压, 电位, 校正, 校准, 标定, 采样, 采集, 跟随器, 分压, reference, criteria, voltage, potential, correction, calibration, sampling, acquisition, follower, division

**C. DOCUMENTS CONSIDERED TO BE RELEVANT**

| Category* | Citation of document, with indication, where appropriate, of the relevant passages | Relevant to claim No. |
| --- | --- | --- |
| X | CN 110174635 A (SVOLT ENERGY TECHNOLOGY CO., LTD.) 27 August 2019 (2019-08-27) description, paragraphs 48-58, and figure 1 | 1-19 |
| X | CN 113114242 A (ELECTRIC POWER RESEARCH INSTITUTE OF GUANGXI POWER GRID CO., LTD.) 13 July 2021 (2021-07-13) description, paragraphs 25-46, and figure 1 | 1-6, 9-19 |
| A | CN 105182057 A (XI'AN YUBANG ELECTRONIC SCIENCE & TECHNOLOGY CO., LTD.) 23 December 2015 (2015-12-23) entire document | 1-19 |
| A | CN 110967560 A (CONTEMPORARY AMPEREX TECHNOLOGY CO., LTD.) 07 April 2020 (2020-04-07) entire document | 1-19 |
| A | CN 111478557 A (PLA INFORMATION ENGINEERING UNIVERSITY) 31 July 2020 (2020-07-31) entire document | 1-19 |

| ☑ Further documents are listed in the continuation of Box C. | ☑ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **08 October 2024** | **24 October 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/109465** |

| C. | DOCUMENTS CONSIDERED TO BE RELEVANT | |
| --- | --- | --- |
| Category* | Citation of document, with indication, where appropriate, of the relevant passages | Relevant to claim No. |
| A | CN 207424216 U (SHANDONG ZHIYANG ELECTRIC CO., LTD.) 29 May 2018 (2018-05-29)<br>entire document | 1-19 |
| A | JP H10227837 A (YOKOGAWA ELECTRIC CORP.) 25 August 1998 (1998-08-25)<br>entire document | 1-19 |

Form PCT/ISA/210 (second sheet) (July 2022)

**INTERNATIONAL SEARCH REPORT**
Information on patent family members

International application No.

**PCT/CN2024/109465**

| Patent document cited in search report | | | Publication date (day/month/year) | Patent family member(s) | | | Publication date (day/month/year) |
|---|---|---|---|---|---|---|---|
| CN | 110174635 | A | 27 August 2019 | CN | 110174635 | B | 31 August 2021 |
| CN | 113114242 | A | 13 July 2021 | CN | 113114242 | B | 24 March 2023 |
| CN | 105182057 | A | 23 December 2015 | None | | | |
| CN | 110967560 | A | 07 April 2020 | WO | 2020177639 | A1 | 10 September 2020 |
| CN | 111478557 | A | 31 July 2020 | CN | 111478557 | B | 23 February 2021 |
| CN | 207424216 | U | 29 May 2018 | None | | | |
| JP | H10227837 | A | 25 August 1998 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311277380